# FASCICULE DE BREVET EUROPEEN

(11) **EP 3 239 013 B1**
(45) Date de publication et mention de la délivrance du brevet: **15.07.2020**
(21) Numéro de dépôt: 17168829.4
(22) Date de dépôt: 28.04.2017
(51) Int. Cl.: B61D 17/00, B61D 17/12, F16B 19/00

(54) **COFFRE POUR ÉQUIPEMENT ÉLECTRIQUE ET VÉHICULE FERROVIAIRE COMPRENANT UN TEL COFFRE**
KASTEN FÜR ELEKTRISCHE AUSRÜSTUNG, UND SCHIENENFAHRZEUG, DAS EINEN SOLCHEN KASTEN UMFASST
CABINET FOR ELECTRICAL EQUIPMENT AND RAIL VEHICLE COMPRISING SUCH A CABINET

(30) Priorité: 29.04.2016 FR 1653893
(43) Date de publication de la demande: 01.11.2017
(73) Titulaire: ALSTOM Transport Technologies, 93400 Saint-Ouen (FR)
(72) Inventeur: PUEL, Bernard, 65310 LALOUBERE (FR); MONETA, Alfredo, 20862 ARCORE (MB) (IT); JAUNIAUX, Pierre, 1340 Ottignies (BE); CHAMIELEC, Olivier, 65290 LOUEY (FR); NARBAIS-JAUREGUY, Catherine, 64000 PAU (FR)
(74) Mandataire: Lavoix

(56) Documents cités:
- DE-A1-102012 221 081
- DE-A1-102013 226 719
- FR-A1- 2 996 683
- US-A1- 2015 322 988
- US-B1- 8 092 128

## Description

La présente invention concerne le domaine des coffres pour équipement électrique, en particulier ceux prévus pour équiper des véhicules ferroviaires.

Les véhicules ferroviaires sont munis d'équipements électriques, tels que des transformateurs, des convertisseurs, des accumulateurs électrochimiques.... Ces équipements électriques sont logés dans des coffres étanches pour les préserver de la poussière et de l'humidité. Ces coffres peuvent être disposés sous le plancher ou sur le toit des véhicules ferroviaires.

FR 2 996 683 A1 divulgue un coffre pour accumulateurs électrochimiques utilisable notamment dans un véhicule ferroviaire.

Un des buts de l'invention est de proposer un coffre qui fournisse une protection efficace tout en étant facile et économique à réaliser.

A cet effet, l'invention propose un coffre pour équipement électrique selon la revendication 1.

Des caractéristiques optionnelles sont définies aux revendications 2 à 9.

L'invention concerne également un véhicule ferroviaire selon la revendication 10.

L'invention et ses avantages seront mieux compris à la lecture de la description qui va suivre, donnée uniquement à titre d'exemple et faite en référence aux dessins annexés, sur lesquels :
- la Figure 1 est une vue schématique en perspective d'un coffre pour équipement électrique, disposé sur le toit d'un véhicule ferroviaire, le coffre comprenant châssis formé d'un assemblage de plaques métalliques ; et
- la Figure 2 est une vue en couche de deux plaques métalliques de l'assemblage, assemblées entre elles par rivetage.

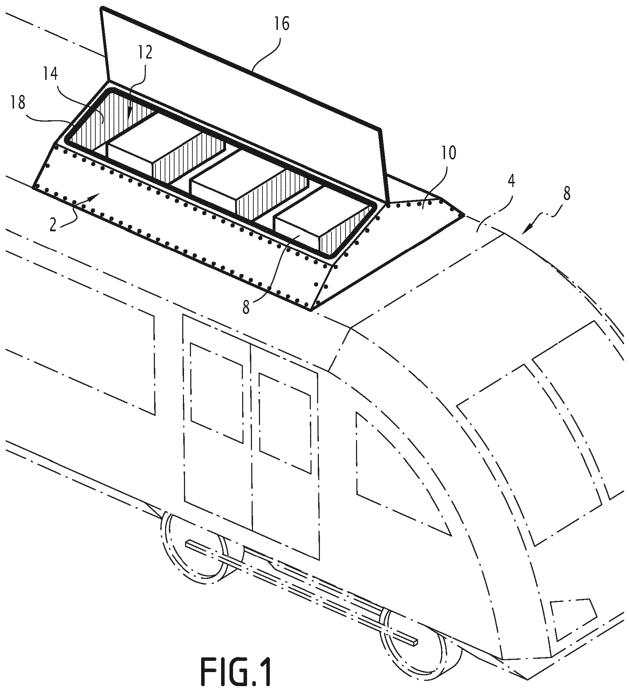

Le coffre 2 pour équipement électrique illustré sur la Figure 1 est disposé sur le toit 4 d'un véhicule ferroviaire 6 et contient des équipements électriques 8 du véhicule ferroviaire. Les équipements électriques 8 comprennent par exemple des transformateurs, des convertisseurs, des accumulateurs électrochimiques...

Le coffre 2 comprend un châssis 10 délimitant un volume de réception 12 recevant des équipements électriques 8. Le châssis 10 est formé d'un assemblage de plaques métalliques en acier galvanisé assemblées entre elles par rivetage.

Le châssis 10 possède une ouverture d'accès 14 pour accéder au volume de réception 12. L'ouverture d'accès 14 permet par exemple de monter les équipements électriques 8 dans le coffre 2 ou de réaliser des opérations de maintenance sur les équipements électriques 8.

Le coffre 2 comprend un couvercle 16 pour fermer l'ouverture. Le couvercle 16 est ici monté mobile par rapport au châssis 10 entre une position fermée, dans laquelle le couvercle 16 ferme l'ouverture d'accès 14, et une position ouverte (Figure 1), dans laquelle le couvercle 16 est dégagé de l'ouverture d'accès 14.

Le coffre 2 comprend un joint d'étanchéité d'ouverture 18 pour assurer l'étanchéité entre le couvercle 16 fermé et le pourtour de l'ouverture d'accès 14. Le joint d'étanchéité d'ouverture 18 est ici disposé sur le châssis 10, le long du pourtour de l'ouverture d'accès 14.

Chaque plaque métallique du châssis est choisie parmi : une plaque plane, une plaque formée en trois dimensions, une plaque pliée ou un profilé.

Un profilé est par exemple une cornière à profil en L possédant deux ailes. Un tel profilé permet de former une pièce d'angle du châssis.

Les plaques métalliques en acier galvanisé sont par exemple galvanisées à chaud.

Les plaques métalliques en acier galvanisé sont munies d'un revêtement au zinc par passage dans un bain comprenant majoritairement du zinc.

Les plaques métalliques sont de préférence en acier super-galvanisé, c'est-à-dire recouverte d'un revêtement à base de zinc, aluminium et magnésium.

Les plaques métalliques en acier super-galvanisé sont munies d'un revêtement au zinc par passage dans un bain comprenant majoritairement du zinc et, en outre, de l'aluminium et du magnésium

Le bain de fusion comprend de préférence entre 1 et 8% d'aluminium et entre 1 et 8 % de magnésium, le reste étant constitué de zinc.

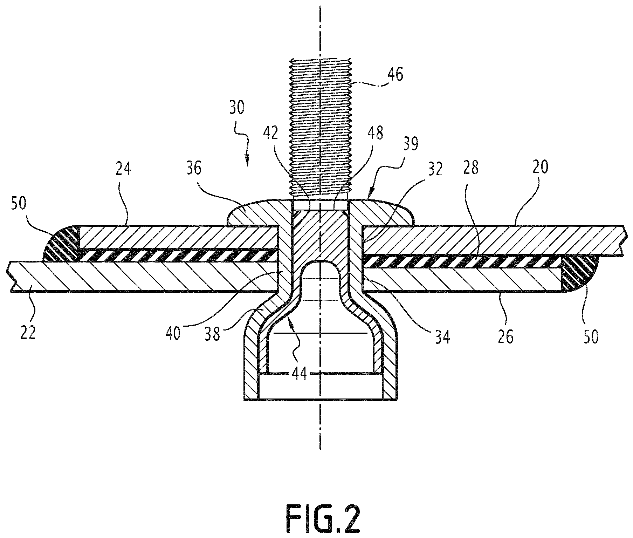

Comme illustré sur la Figure 2, les deux plaques métalliques 20, 22 de chaque paire de plaques métalliques 20, 22 assemblées entre elles, possèdent des régions de recouvrement 24, 26 respectives qui se recouvrent entre elles et qui sont assemblées par rivetage, un mastic d'étanchéité 28 étant interposé entre les régions de recouvrement 24, 26.

La zone où les régions de recouvrement 24, 26 de deux plaques métalliques 20, 22 assemblées entre elles se recouvrent est une zone de recouvrement.

Chaque région de recouvrement 24, 26 est délimitée par un bord de la plaque métallique 20, 22 correspondante. Chaque région de recouvrement 24, 26 est une région marginale de la plaque métallique 20, 22 correspondante. La zone de recouvrement est située entre les bords des deux plaques métalliques 20, 22 délimitant les régions de recouvrement 24, 26 se recouvrant l'une l'autre.

Avantageusement, le mastic d'étanchéité 28 affleure le long du bord de chaque plaque métallique 20, 22 qui délimite la région de recouvrement 24, 26 de cette plaque métallique 20, 22.

Avantageusement encore le mastic d'étanchéité 28 est disposé uniquement sur une fraction de la largeur de la zone de recouvrement prise entre les bords des plaques métalliques 20, 22. Le mastic d'étanchéité 28 est disposé uniquement au niveau de deux zones d'étanchéité qui affleurent chacune le long du bord d'une plaque métallique 20, 22 respective, et qui sont situées de part et d'autre d'une zone intermédiaire dépourvue de mastic d'étanchéité. La largeur de chaque zone d'étanchéité est par exemple inférieure à 35%, de préférence à 25%, de la largeur de la zone de recouvrement.

Les régions de recouvrement 24, 26 sont en appui l'une sur l'autre par leurs faces en regard, par l'intermédiaire du mastic d'étanchéité 28. Elles ne sont pas directement en contact l'une avec l'autre.

Les deux plaques 20, 22 métalliques sont assemblées entre elles au moyen de rivets 30, un seul rivet étant visible sur la Figure 2.

Chaque rivet 30 traverse un orifice de rivetage 32, 34 de chaque région de recouvrement 24, 26, les orifices de rivetage 32, 34 des deux régions de recouvrement 24, 26 étant alignés l'un avec l'autre.

Chaque rivet 30 prend appui sur la face de chaque région de recouvrement 24, 26 opposée à l'autre région de recouvrement 24, 26.

Chaque rivet 30 possède une tête de rivet 36 et une rivure 38. La rivure 38 est une partie du rivet 30 déformée après insertion du rivet 30 dans les orifices de rivetage 32, 34 pour assembler les deux plaques métalliques 20, 22 entre elles. Chaque rivet 30 assure la continuité électrique entre les plaques métalliques 20, 22, sachant que le mastic d'étanchéité 28 est généralement un isolant électrique.

Les régions de recouvrement 24, 26 sont maintenues entre la tête de rivet 36 et la rivure 38. La tête de rivet 36 est en appui sur une région de recouvrement 24, 26 et la rivure 38 est en appui sur l'autre.

Chaque rivet 30 est un rivet aveugle. Chaque rivet 30 comprend un corps de rivet 39 comprenant une tige de rivet 40 creuse munie d'un orifice interne 42 et la tête de rivet 36 disposée à une première extrémité de la tige de rivet 40, et un mandrin 44 déplaçable en force dans l'orifice interne 42 de la tige de rivet 40 pour déformer la deuxième extrémité de la tige de rivet 40 par expansion radiale et former la rivure 38.

Initialement, la tige de rivet 40 à l'état non déformé est insérable dans les orifices de rivetage 32, 34 des régions de recouvrement 24, 26. Ensuite, le déplacement axial du mandrin 44, au moyen d'un outil de rivetage, provoque la déformation de la deuxième extrémité de la tige de rivet 40 par expansion radiale et la formation de la rivure 38, de sorte que les régions de recouvrement 24, 26 sont rivetées.

Pour déplacer le mandrin 44 dans la tige de rivet 40, la mandrin 44 est par exemple lié initialement à une tige de traction 46 (représentée en traits mixtes) s'étendant à travers la tige de rivet 40 et sortant du côté de la première extrémité munie de la tête de rivet 36, la tige de traction 46 étant liée au mandrin 44 par une liaison frangible 48 calibrée pour rompre sous un effort de traction prédéterminé. L'effort de traction prédéterminé est prévu de telle sorte que la liaison frangible rompt lorsqu'une déformation adéquate de la tige de rivet 40 est atteinte, permettant d'assurer l'assemblage entre les plaques métalliques 20, 22.

L'insertion du mandrin 44 provoque l'expansion radiale de la deuxième extrémité de la tige de rivet 40 formant ainsi la rivure 38. Elle provoque également l'expansion radiale du tronçon intermédiaire de la tige de rivet 40 reçu dans les orifices de rivetage 32, 34 de sorte que la tige de rivet 40 est en contact étanche avec les surface internes des orifices de rivetage 32, 34.

Sur la Figure 2, l'orifice interne 42 est traversant et débouche aux deux extrémités axiales de la tige de rivet 40. Le mandrin 44 est inséré en force dans la tige de rivet 40 pour former la rivure 38, et une fois inséré, il ferme l'orifice interne 42 de manière étanche.

En variante, la tige de rivet 40 possède un fond fermant l'orifice interne 42 à une extrémité, de préférence la deuxième extrémité de la tige de rivet 40. L'orifice interne 42 est par exemple muni d'un étranglement, et le déplacement axial du mandrin 44 provoque l'expansion radiale de la tige de rivet 40 au droit de l'étranglement.

Dans tous les cas, le rivetage d'un rivet 30 se fait depuis un seul côté des plaques métalliques 20, 22. Sur la Figure 2, le rivet 30 à l'état initial non déformé est inséré de haut en bas dans les orifices de rivetage 32, 34 alignés, puis la tige de traction 44, qui fait saillie vers le haut, est tirée de bas en haut en retenant le corps de rivet 39 en appuyant sur la tête de rivet 40. Le rivet 30 est ainsi installé en intervenant seulement du côté des plaques métalliques 20, 22 situé en haut sur la Figure 2, sans avoir à accéder du côté des plaques métalliques 20, 22 situé en bas sur le Figure 2.

Le mastic d'étanchéité 28 est disposé entre les régions de recouvrement 24, 26 de manière à réaliser un joint intercalaire continu interposé entre les régions de recouvrement 24, 26. Le joint intercalaire s'étend en particulier autour des orifices de rivetage 32, 34 et des rivets 30 traversant les orifices de rivetage 32, 34.

Avantageusement, le mastic d'étanchéité 38 est réalisé en polyuréthane ou en polymère modifié silane.

Avantageusement, un joint de bord 50 est disposé le long des bords des plaques métalliques 20, 22 délimitant les régions de recouvrement 24, 26. Chaque joint de bord 50 est par exemple déposé le long d'un bord d'une des plaques métalliques 20, 22 et sur une face de l'autre plaque métallique 20, 22.

Chaque joint de bord 50 est de préférence en contact avec le mastic d'étanchéité 28, avantageusement sur toute la longueur du mastic d'étanchéité 28.

Les plaques métalliques 20, 22 sont de préférence non peintes. Elles ne sont pas recouvertes d'un revêtement de peinture. L'absence de peinture des plaques métalliques permet de réduire le temps de fabrication, de réduire le coût de fabrication et de réduire le poids du coffre.

Les plaques métalliques 20, 22 en acier galvanisé, en particulier lorsqu'elles sont recouverte d'un revêtement au zinc contenant de l'aluminium et du magnésium comme mentionné précédemment, présentent une résistance à la corrosion satisfaisante.

L'assemblage des plaques métalliques 20, 22 à l'aide de rivets 30, en particulier de rivets aveugles, avec interposition d'un mastic d'étanchéité 28, en particulier en polyuréthane, entre les régions de recouvrement 24, 26, permet d'obtenir une étanchéité satisfaisante.

En outre les joint de bord 50 offrent une étanchéité améliorée, notamment lorsqu'ils sont en contact avec le mastic d'étanchéité 28.

L'étanchéité est suffisante pour une application ferroviaire, sans qu'il soit nécessaire notamment de peindre le coffre. Il est en particulier possible d'obtenir un indice de protection IPX6 selon le standard d'indice de protection relatif à l'étanchéité, établi par la Commission électrique internationale et repris par la norme européenne EN 60529.

Les plaques métalliques 20, 22 assemblées sont fixées entre elles uniquement par rivetage, sans autre fixation mécanique supplémentaire. Les plaques métalliques assemblées ne sont notamment pas soudées entre elles, ni vissées entre elles.

L'assemblage des plaques métalliques 20, 22 par rivetage peut être réalisé facilement et à faible coût, avec un nombre d'outils limité et par un nombre d'opérateurs limité.

En particulier, l'assemblage au moyen de rivets aveugles est réalisable depuis un seul côté des plaques métalliques à assembler, sans nécessiter d'accéder à l'autre côté des plaques métalliques à assembler. Le rivetage est réalisé facilement, sans avoir besoin de connaissance ou de technique particulière.

Le couvercle est formé d'une plaque métallique ou d'un assemblage de plaques métalliques. Chaque paque métallique est de préférence constituées du même matériau que les plaques métalliques du châssis, i.e. de préférence un acier galvanisé à chaud revêtu d'un revêtement au zinc contenant de l'aluminium et du magnésium, et non peinte. Le cas échéant, les plaques métalliques du couvercle sont assemblées entre elles de la même manière que les plaques métalliques du châssis, i.e. de préférence par rivetage avec interposition d'un joint d'étanchéité.

## Revendications

1. Coffre pour équipement électrique d'un véhicule ferroviaire, le coffre délimitant un volume de réception d'équipements électriques, et étant formé par un assemblage de plaques métalliques (20, 22) en acier galvanisé, les plaques métalliques de chaque paire de plaques métalliques (20, 22) assemblées entre elles ayant des régions de recouvrement (24, 26) qui se recouvrent l'une l'autre et qui sont assemblées par l'intermédiaire de rivets (30) traversant les régions de recouvrement (24, 26), **caractérisé en ce qu'**un mastic d'étanchéité (28) est interposé entre les régions de recouvrement (24, 26), les plaques métalliques étant réalisées en acier galvanisé avec un revêtement à base de zinc, aluminium et magnésium.

2. Coffre selon la revendication 1, dans lequel les plaques métalliques (20, 22) de l'assemblage sont réalisées en acier galvanisé d'un revêtement au zinc contenant entre 1 et 8% d'aluminium et entre 1 et 8 % de magnésium.

3. Coffre selon la revendication 1 ou la revendication 2, dans lequel, chaque région de recouvrement (24, 26) étant délimité par un bord de la plaque métallique (20, 22) correspondante, un joint de bord (50) est disposé le long du bord de chaque plaque métallique (20, 22), chaque joint de bord (50) étant en contact avec le mastic d'étanchéité (28) interposé entre les régions de recouvrement (24, 26).

4. Coffre selon la revendication 3, dans lequel chaque joint de bord (50) est disposé le long du bord d'une des plaques métalliques et sur une face de l'autre plaque métallique.

5. Coffre selon l'une quelconque des revendications précédentes, dans lequel les plaques métalliques (20, 22) de l'assemblage ne sont pas peintes.

6. Coffre selon l'une quelconque des revendications précédentes, dans lequel les plaques métalliques (20, 22) de l'assemblage sont assemblées entre elles uniquement par rivetage.

7. Coffre selon l'une quelconque des revendications précédentes, dans lequel chaque plaque métallique (20, 22) de l'assemblage est choisie parmi une plaque plane, une plaque pliée et un profilé.

8. Coffre selon l'une quelconque des revendications précédentes, dans lequel les rivets (30) sont des rivets aveugles.

9. Coffre selon la revendication 8, dans lequel chaque rivet aveugle comprend un corps de rivet possédant une chemise possédant orifice, une tête disposée à une première extrémité de la chemise, et un mandrin d'expansion inséré dans la chemise de manière à déformer une deuxième extrémité de la chemise par expansion radial.

10. Véhicule ferroviaire comprenant un coffre selon l'une quelconque des revendications précédentes.

## Patentansprüche

1. Kasten für eine elektrische Ausrüstung von eines Schienenfahrzeugs, wobei der Kasten ein Volumen zur Aufnahme von elektrischen Ausrüstungen begrenzt und von einer Baugruppe aus Metallplatten (20, 22) aus galvanisiertem Stahl gebildet ist, wobei die Metallplatten jedes Paars von zueinander zusammengesetzten Metallplatten (20, 22) Überdeckungsbereiche (24, 26) aufweisen, die einander überdecken und die mittels Nieten (30) zusammengesetzt sind, die die Überdeckungsbereiche (24, 26) durchgreifen, **dadurch gekennzeichnet, dass** eine Dichtungsmasse (28) zwischen den Überdeckungsbereichen (24, 26) angeordnet ist, wobei die Metallplatten aus galvanisiertem Stahl mit einer Beschichtung auf Basis von Zink, Aluminium und Magnesium hergestellt sind.

2. Kasten nach Anspruch 1, bei dem die Metallplatten der Baugruppe aus mit einer Zinkbeschichtung galvanisiertem Stahl, die zwischen 1 und 8% Aluminium und zwischen 1 und 8% Magnesium enthält, hergestellt sind.

3. Kasten nach Anspruch 1 oder Anspruch 2, bei dem jeder Überdeckungsbereich (24, 26) von einem Rand der entsprechenden Metallplatte (20, 22) begrenzt ist, wobei eine Randdichtung (50) entlang des Randes jeder Metallplatte (20, 22) angeordnet ist und jede Randdichtung (50) in Kontakt mit der Dichtungsmasse (28) ist, die zwischen den Überdeckungsbereichen (24, 26) angeordnet ist.

4. Kasten nach Anspruch 3, bei dem jede Randdichtung (50) entlang des Randes einer der Metallplatten und auf einer Fläche der anderen Metallplatte angeordnet ist.

5. Kasten nach einem beliebigen der vorhergehenden Ansprüche, bei dem die Metallplatten (20, 22) der Baugruppe nicht angestrichen sind.

6. Kasten nach einem beliebigen der vorhergehenden Ansprüche, bei dem die Metallplatten (20, 22) der Baugruppe untereinander nur durch Nieten zusammengefügt sind.

7. Kasten nach einem beliebigen der vorhergehenden Ansprüche, bei dem jede Metallplatte (20, 22) der Baugruppe ausgewählt ist aus einer planen Platte, einer gefalteten Platte oder einem Profil.

8. Kasten nach einem beliebigen der vorhergehenden Ansprüche, bei dem die Nieten (30) Blindnieten sind.

9. Kasten nach Anspruch 8, bei dem jeder Blindniet einen Nietenkörper umfasst, der einen mit einem Loch versehenen Schaft, einen Kopf, der an einem ersten Ende des Schaftes angeordnet ist, und einen Aufweitdorn, der in den Schaft eingesetzt ist, um ein zweites Ende des Schaftes durch radiale Aufweitung zu verformen, besitzt.

10. Schienenfahrzeug, einen Kasten nach einem beliebigen der vorhergehenden Ansprüche umfassend.

## Claims

1. A cabinet for electrical equipment of a rail vehicle, the cabinet defining a volume for receiving electrical equipment, and being formed by an assembly of metal plates (20, 22) made from galvanized steel, the metal plates of each pair of metal plates (20, 22) assembled to one another having overlapping regions (24, 26) that overlap one another and that are assembled via rivets (30) traversing the overlapping regions (24, 26), **characterized in that** a sealing putty (28) is interposed between the overlapping regions (24, 26), the metal plates being made of galvanized steel with a coating having a base of zinc, aluminum and magnesium.

2. The cabinet according to claim 1, wherein the metal plates (20, 22) of the assembly are made from galvanized steel with a zinc coating containing between 1 and 8% aluminum and between 1 and 8% magnesium.

3. The cabinet according to claim 1 or claim 2, wherein, each overlapping region (24, 26) being defined by an edge of the corresponding metal plates (20, 22), an edge joint (50) is positioned along the edge of each metal plate (20, 22), each edge joint (50) being in contact with the sealing putty (28) inserted between the overlapping regions (24, 26).

4. The cabinet according to claim 3, wherein each edge joint (50) is positioned along the edge of one of the metal plates and over a face of the other metal plate.

5. The cabinet according to any one of the preceding claims, wherein the metal plates (20, 22) of the assembly are not painted.

6. The cabinet according to any one of the preceding claims, wherein the metal plates (20, 22) of the assembly are assembled to one another only by riveting.

7. The cabinet according to any one of the preceding claims, wherein each metal plate (20, 22) of the assembly is chosen from among a planar plate, a bent plate and a profile.

8. The cabinet according to any one of the preceding claims, wherein the rivets (30) are blind rivets.

9. The cabinet according to claim 8, wherein each blind rivet comprises a rigid body having a jacket with an orifice, a head positioned at a first end of the jacket, and an expansion mandrel inserted in the jacket so as to deform a second end of the jacket by radial expansion.

10. A rail vehicle comprising a cabinet according to any one of the preceding claims.
